Europäisches Patentamt

European Patent Office

Office européen des brevets

(19)

(11) Publication number: **0 020 047**
**B1**

(12) **EUROPEAN PATENT SPECIFICATION**

(45) Date of publication of patent specification: **09.01.85**

(51) Int. Cl.⁴: **G 01 R 31/04,** H 02 J 13/00

(21) Application number: **80301560.1**

(22) Date of filing: **13.05.80**

(54) Method and apparatus for fault identification in electric power transmission systems.

(30) Priority: **16.05.79 GB 7916937**

(43) Date of publication of application:
**10.12.80 Bulletin 80/25**

(45) Publication of the grant of the patent:
**09.01.85 Bulletin 85/02**

(84) Designated Contracting States:
**CH DE FR LI SE**

(56) References cited:
**CH-A- 462 955**
**FR-A-1 416 357**
**GB-A-1 275 560**

(73) Proprietor: **The General Electric Company, p.l.c.**
**1 Stanhope Gate**
**London W1A 1EH (GB)**

(72) Inventor: **Owen, Michael**
**Hathaway House Hay Road**
**Builth Wells Powys LD2 3BP (GB)**
Inventor: **Sanderson, John Victor Harold**
**15 Sutton Road**
**Alderley Edge Cheshire (GB)**

(74) Representative: **Pope, Michael Bertram Wingate**
**Central Patent Department Wembley Office The**
**General Electric Company, p.l.c. Hirst Research**
**Centre East Lane**
**Wembley Middlesex HA9 7PP (GB)**

The file contains technical information
submitted after the application was filed and
not included in this specification

Courier Press, Leamington Spa, England.

EP 0 020 047 B1

# 0 020 047

**Description**

This invention relates to a method of and an apparatus for protecting polyphase alternating current electric power transmission systems against faults.

Such methods and apparatus are required to identify the type of fault that has occurred so that appropriate action to protect the transmission system can be taken. To this end many different schemes of varying degrees of sophistication have been proposed. Whilst many such schemes operate satisfactorily for most types of fault, a comprehensive fault identification method which will satisfactorily identify all likely types of fault is not presently available. Thus existing methods frequently exhibit shortcomings such as: incorrect discrimination between fault and load currents; incorrect identification of fault type, particularly in respect of double phase to earth faults; load encroachments; and excessive time to identify faults. One such method in which fault type is determined by monitoring the relative values of certain fault current quantities is described in the United Kingdom Patent Specification GB—A—1,275,560.

Thus, known schemes capable of reasonably comprehensive fault identification either exhibit shortcomings or are highly sophisticated and complex, and frequently employ different fault identification methods for different types of fault.

It is an object of the present invention to provide a method and apparatus for identifying faults in a polyphase alternating current electric power transmission system wherein this problem is overcome.

According to one aspect of the present invention there is provided a method of identifying faults in a polyphase alternating current electric power transmission system wherein identification of the type of fault occurring is effected by monitoring a plurality of signals each of which is representative of a respective one of a plurality of fault current quantities, each of which quantities is a linear function of at least one phase fault current of the system, the phase fault currents being defined by the respective differences between the prefault and the post-fault currents on the individual phase lines of the system, characterised in that said signals are utilised to determine whether a predetermined phase relation exists between selected ones of said fault current quantities and whether selected ones of said fault current quantites exist, the selected fault current quantities and said predetermined phase relation being such that the result of said determination indicates whether a particular type of fault is present.

In a preferred arrangement in accordance with the invention each said fault current quantity is a phase fault current of the system or a quantity derived by addition or subtraction of phase fault currents of the system.

In one such preferred arrangement for use in a three-phase system, said fault current quantities are at least some of the quantities Ir, Iy, Ib, Ir+Iy+Ib, Ir+Iy, Iy+Ib, Ib+Ir, Ir—Iy, Iy—Ib and Ib—Ir, where Ir, Iy and Ib are the respective phase fault currents.

The particular methods which may be utilised to identify particular types of faults and the particular phase or phases involved are further explained below.

In one particular method in accordance with the invention the direction of an identified fault is determined by comparing the phases of a post fault current relating to the faulted phase or phases and the corresponding pre-fault voltage.

It is pointed out that whilst the method according to the invention and the method of GB—A—1,275,560 both use fault current quantities to identify fault type, the manner in which fault current quantities are investigated to determine fault type is different in the method according to the invention.

In addition to being capable of identifying all likely types of fault, a method according to the present invention has the advantage that; except where fault direction is determined, no voltage transformers are required; it suffers less from travelling wave distortion than methods using voltage quantities; and it is particularly adapted for execution by a digital computer, or other computer means capable of logical analysis of inputs.

Hence, according to a second aspect of the invention there is provided an apparatus for identifying faults in a polyphase alternating current electric power transmission system comprising: a plurality of current transducer means for producing respective output signals representing the phase currents of the system; and means arranged to derive from said transducer output signals a plurality of further signals each of which is representative of a respective one of a plurality of fault current quantities, each of which quantities is a linear function of at least one phase fault current of the system, the phase fault currents being defined by the respective differences between the pre-fault and the post-fault currents on the individual phase lines of the system, said means being arranged to monitor said further signals to identify the type of fault occurring in the system, characterised in that said means comprises computer means programmed to utilise said further signals to determine whether a predetermined phase relation exists between selected ones of said fault current quantities and whether selected ones of said fault current quantities exist, the selected current quantities and said predetermined phase relation being such that the result of said determination indicates how many phases a fault condition occurring in the system involves and whether ground is involved in the fault condition.

The computer may be further programmed to determine the direction of a fault.

By way of further explanation of the invention, and by way of example, one method and apparatus

2

for detecting faults in a three phase transmission system will now be described with reference to the accompanying drawings in which:—

Figure 1 is a diagrammatic representation of a three phase electric power transmission system;

Figure 2 is a diagrammatic representation of the system of Figure 1 in a faulted condition;

Figure 3(a) to 3(f) are Thevenin fault current diagrams for various types of fault condition in the system;

Figure 4 is a block schematic diagram of the apparatus;

Figures 5 and 6 are flow charts illustrating a programme carried out by a computer forming part of the apparatus; and

Figure 7 is a diagram of a circuit used in the apparatus in identifying the direction of faults.

The method is based on the realisation by the inventors that when a fault occurs on a transmission system the resulting fault currents can be analysed to determine what type of fault has occurred. This can be demonstrated, as follows:

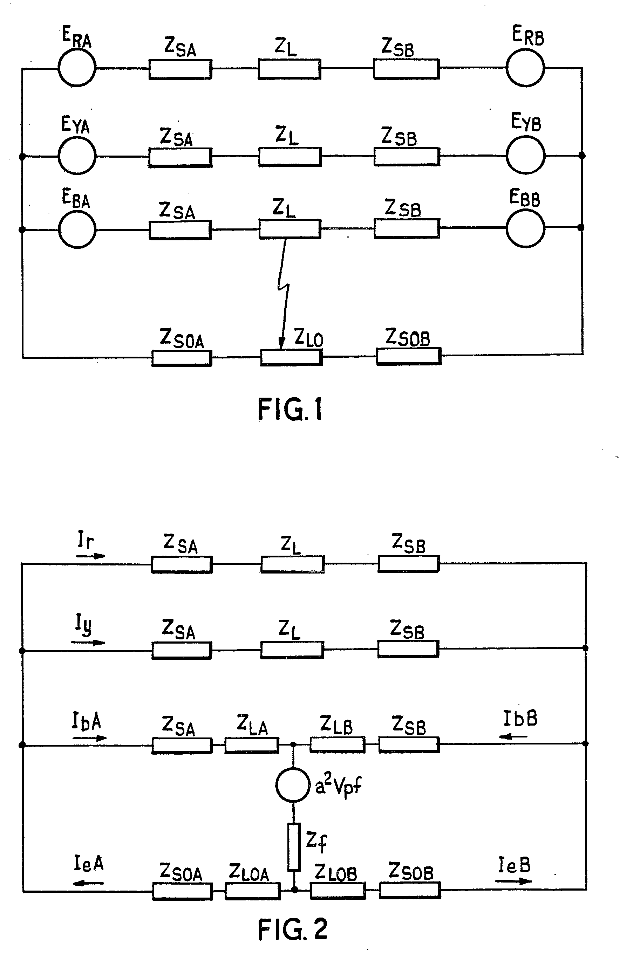

Referring to Figure 1, a three-phase power transmission system may be considered as comprising a length of line of impedance $Z_L$ per phase connecting two sources A and B producing red, yellow and blue phase voltages $E_{RA}$, $E_{YA}$, $E_{BA}$ and $E_{RB}$, $E_{YB}$, $E_{BB}$, the sources A and B having impedances $Z_{SA}$ and $Z_{SB}$ per phase. The impedances $Z_{SOA}$, $Z_{LO}$ and $Z_{SOB}$ represent the mutual impedances of the system whilst the impedances $Z_{SA}$, $Z_L$ and $Z_{SB}$ represent the self impedances of the system.

By application of Thevenin's theorem, the fault currents which flow when a fault occurs, e.g. between the blue phase and ground as indicated in Figure 1, can be determined by considering the voltage sources A and B to be short-circuited, and a voltage source equal to the voltage at the fault point before the fault occurred connected across the fault point in series with the fault impedance $Z_F$. This is shown in Figure 2 where Vpf is the red phase pre-fault voltage at the fault point, $a$ is the phase operator—0.5+j 0.866, and Ir, Iy and Ib are the red, yellow and blue phase fault currents respectively, current Ib having oppositely directed components IbA and IbB on opposite sides of the fault point, and the ground current having similar components IeA and IeB. It will be appreciated that the fault currents Ir, Iy and Ib are the changes in the phase currents which occur when a fault occurs, i.e. the differences between the pre-fault (load) phase currents and the post-fault phase currents, i.e. the total currents in the system under fault conditions.

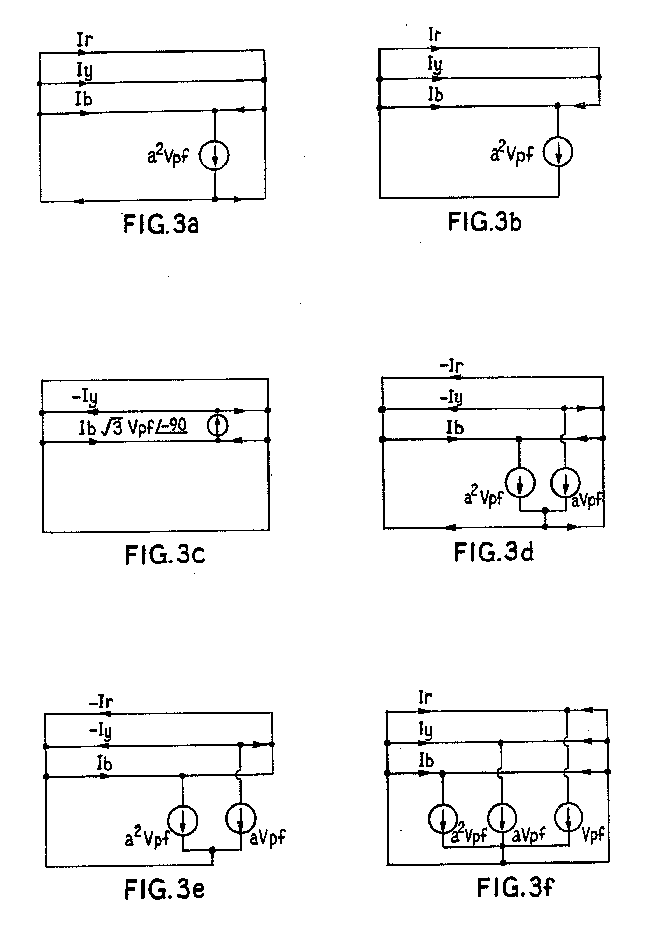

Figure 3(a) is a Thevenin fault current diagram for a ground fault on the blue phase with the impedances omitted for simplicity. For such a fault the following conditions hold:

Ir+Iy+Ib exists (i.e. is finite)

Iy—Ib and Ib—Ir exist and are in-phase or antiphase with Ir+Iy+Ib

Ir—Iy is zero

The presence of a blue phase ground fault can thus be identified uniquely by determining that Ir+Iy+Ib exists, that the two difference currents Iy—Ib and Ib—Ir involving the blue phase exist and are in phase or antiphase with Ir+Iy+Ib, and that the other difference current Ir—Iy is zero.

Similar sets of conditions uniquely identify the presence of red phase to ground and yellow phase to ground faults.

Referring to Figures 3b if one source is not grounded so that Ir+Iy+Ib does not exist, the following condition identifies the presence of a single phase to ground fault.

Ir+Iy, Iy+Ib and Ib+Ir all exist and are respectively in phase or antiphase with Ib, Ir and Iy.

The particular faulted phase red, yellow or blue can then be identified, as before, by examination of Ir—Iy, Iy—Ib and Ib—Ir.

It will be noted that, in the case of single phase faults the current quantities Ir, Iy, Ib, Ir+Iy, Iy+Ib, Ib+Ir, and Ir+Iy+Ib are all in phase or anti-phase with one another although, depending on whether the system souces are grounded and whether the fault point is to the left or right of the current monitoring point, some of these quantities may not exist. Thus, to establish phase relations, the various current quantities are interchangeable.

Figure 3(c) is a Thevenin fault current diagram for yellow phase to blue phase fault when the following conditions hold:—

Ir+Ib+Iy does not exist

Iy+Ib does not exist

Ib+Ir exists and is anti-phase with Ir+Iy.

The presence of a yellow phase to blue phase fault can thus be uniquely identified by determining that Ir+Ib+Iy and the sum current Iy+Ib do not exist, and that the other sum currents Ib+Ir and Ir+Iy exist and are in anti-phase.

The other phase to phase faults can be similarly identified.

It will be noted that in general for a phase to phase fault, only positive and negative sequence quantities exist, and the positive sequence current is anti-phase with the negative sequence current. The sound phase conductor appears to the fault generator like an extra earth conductor and since no zero sequence current flows, no sound phase current exists. Thus, the identification of a phase to phase fault could also be made using the following set of conditions, the case of a yellow and blue phase fault again being considered by way of example.

Ir+Iy+Ib does not exist
Ir does not exist
Iy exists and is anti-phase with Ib.

The fact that Iy and Ib exist indicates the fault is between these phases.
The following set of conditions could also be used

Ir+Iy+Ib does not exist
Iy—Ib does not exist
Ib—Ir exists and is anti-phase with Ir—Iy.

The fact that the finite quantities both involve Ir indicates that the red phase is sound and the fault is therefore between yellow and blue phases.
Figure 3(d) is a Thevenin fault current diagram for a yellow and blue phases to ground fault when the following conditions exist.

Ir+Iy+Ib exists
Ir+Iy, Iy+Ib and Ib+Ir all exist but only
Iy+Ib is in phase or anti-phase with Ir+Iy+Ib.

The presence of a yellow and blue phases to ground fault can thus be uniquely identified by determining that Ir+Iy+Ib, Ir+Iy, Iy+Ib and Ib+Ir all exist and that only the sum current Iy+Ib is in phase or anti-phase with Ir+Iy+Ib.
Referring to Figure 3(e) if one source is not grounded so that Ir+Iy+Ib does not exist, the following condition can be used to detect the existence of a yellow and blue phases to ground fault.

Ir+Iy, Iy+Ib and Ib+Ir all exist but only
Ir+Ib is in phase or anti-phase with Ir.

The presence of such a fault can thus be uniquely identified by determining that the sum currents all exist and that only the sum current Iy+Ib is in phase or anti-phase with the other phase current Ir.
The other two phase faults to ground can be similarly identified.
In general terms, for a two phases to ground fault both second phase and earth return currents are zero sequence quantities so that, by Kirchoff's current law, the sum of the currents in the faulted phases must also be a zero sequence quantity.
Figure 3(f) is a Thevenin fault current diagram for a three phases to ground fault when the following conditions exist

Ir+Iy+Ib does not exist
Ir+Iy, Iy+Ib, Ib+Ir exist and are at 120° separations.

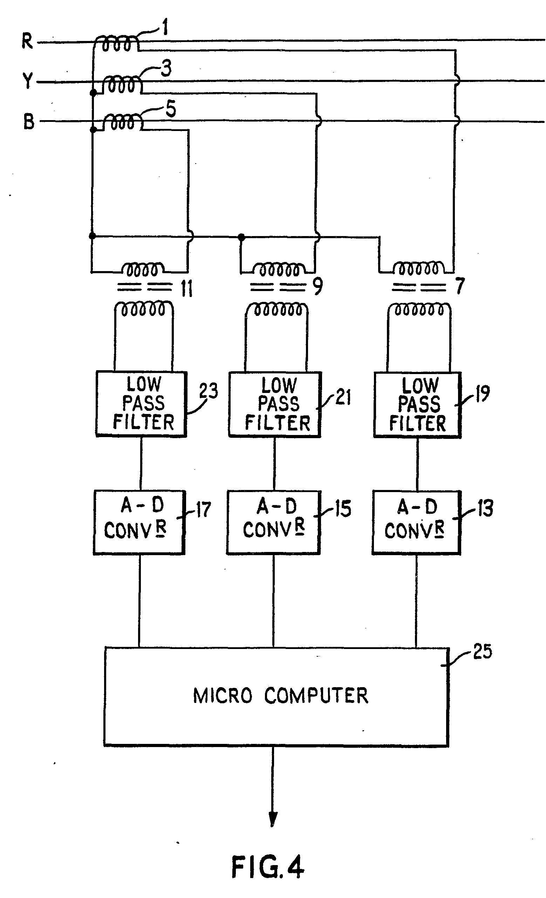

This condition uniquely identifies a three phase fault to ground fault.
It will be appreciated that this applies equally to a three phase fault between phases not involving ground.
In general terms for a three phase fault all sets of corresponding current quantites are at 120° separations. Thus a three phase fault can alternatively be identified by determining that Ir+Iy+Ib does not exist and Ir, Iy and Ib, or Ir—Iy, Iy—Ib and Ib—Ir all exist and are at 120° separations.
It will be appreciated that in a practical implementation of the above fault identification method the fault phase currents Ir, Iy, Ib and the current quantities derived therefrom will be considered to exist only when they exceed certain set minimum values. Similarly, quantities will be considered to be in phase or anti-phase or at 120° separation so long as their phase difference is within a set amount of 0°, 180° or 120° respectively.
The set values for determining existence of quantities are suitably determined by considering a single phase to ground fault of maximum fault resistance at the far end of the protected line section with minimum source MVA. The set value for Ir+Iy+Ib is suitably taken as this fault current times the attenuation introduced by the current measuring apparatus used. The set values for Ir, Iy, Ib, Ir—Iy, Iy—Ib and Ib—Ir are suitably made the same, and the set values for Ir+Iy, Iy+Ib and Ib+Ir are suitably made twice that for Ir+Iy+Ib.
One apparatus for detecting three phase transmission system faults using the above described method will now be described.
Referring to Figure 4, the apparatus includes three current transformers 1, 3 and 5 by means of which currents representative of the red, yellow and blue phase currents of the system are respectively supplied to three transactors 7, 9, and 11. The transactors convert their input currents to corresponding voltages and remove any d.c. offsets which may be present. The transactor output voltages are supplied to analogue to digital converters 13, 15 and 17 via respective low pass filters 19, 21 and 23 which remove any high frequency components which may be present. The outputs of the converters 13, 15, and 17, which comprise digital signals representing samples of the instantaneous values of the phase currents, are supplied to a micro computer 25.

In the micro computer 25 fault identification is carried out using fault current quantities. To obtain these quantities the computer memory stores phase current instantaneous value samples supplied by the converters 13, 15 and 17 in respect of at least a quarter of a cycle of the system waveform, typically one half cycle. As each new value sample is received it is subtracted from the stored value sample relating to the same point on wave as the new sample, and the stored sample is then discarded and replaced in the memory by the new sample. The results of the subtractions are passed to the central processing unit of the computer 25 where they are analysed as further described below.

It will be apparent that for a period following a fault equal to that over which samples are stored, the results of the subtractions indicate phase fault currents.

The computer is programmed to calculate from the phase fault currents Ir, Iy, Ib the other fault current quantities required for fault identification i.e. Ir+Iy+Ib, Ir+Iy, Iy+Ib, Ib+Ir, Ir—Iy, Iy—Ib and Ib—Ir.

The amplitude and phase of each fault current quantity relative to a common time reference is then calculated by the computer using the algorithms

$$\phi = \arctan \left[ \frac{\sin \omega \Delta t}{\dfrac{i_2}{i_1} - \cos \omega \Delta t} \right] - \omega t_1 \tag{A}$$

and

$$\hat{I} = \frac{i_1}{\sin \left( \arctan \left[ \frac{\sin \omega \Delta t}{\dfrac{i_2}{i_1} - \cos \omega \Delta t} \right] \right)} \tag{B}$$

where

$\phi$ is the phase of the current quantity relative to the time reference

$\hat{I}$ is the amplitude of the current quantity

$i_1$ and $i_2$ are samples of the instantaneous values of the current quantity at times $t_1$ and $t_1 + \Delta t$ after the time reference and

$\omega$ is the angular frequency of the system.

The computer monitors the current quantity amplitudes using the algorithm B (for which no time reference is required) and indicates when these meet the operating limits determined by the set values described above.

Once a limit has been exceeded the relative phase angles required for fault detection are also calculated using the algorithm A and using the time at which the limit was first exceeded as the time reference.

Having established whether the various quantities exist and their relative phase angles the computer then utilises the above described method to identify the type of fault that has occurred, and the phase or phases involved in the fault.

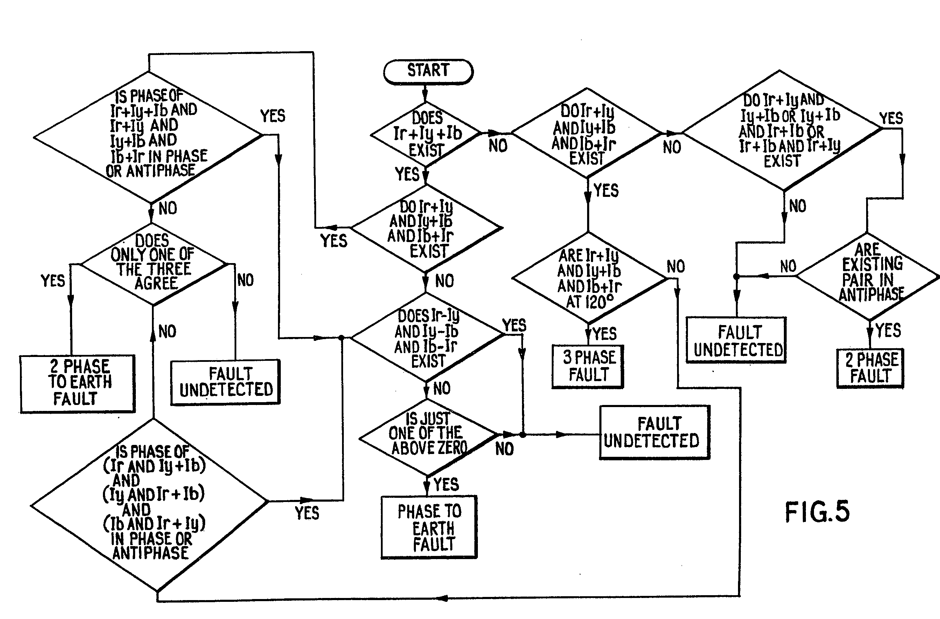

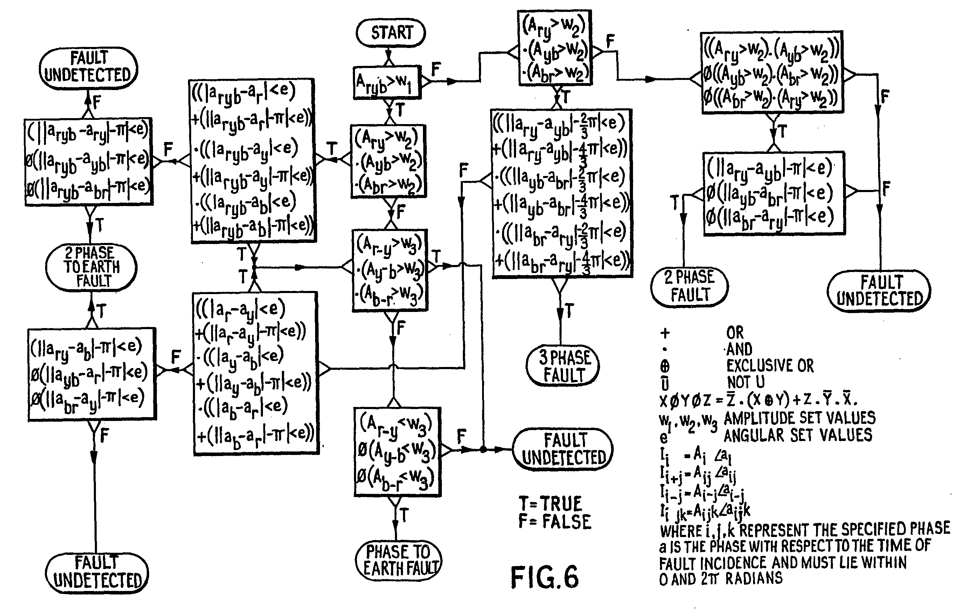

Figure 5 is a flow chart which gives a general idea of the process involved in fault identification whilst Figure 6 is a flow chart which shows the actual logic steps which the computer is programmed to carry out. Taken together with the above description of the conditions for identifying the different types of fault, Figures 5 and 6 are self-explanatory.

Having identified the type of fault that has occurred the computer determines the actual phase or phases involved in the fault, using the method described above.

Thus, for single phase to ground faults the faulted phase is indicated by the absence of the faulted phase current in the difference current quantity which is zero.

For two phase faults the sound phase is the phase whose current appears in the two sum currents which exist.

For two phase to ground faults the faulted phases are the phases for which the sum current is in phase or anti-phase with Ir+Iy+Ib, or in the case of non-earthed sources, the other phase current.

For three phase faults no phase selection is required.

Having identified the phase or phases involved in the fault, the computer passes appropriate command signals to circuit breaker control equipment (not shown).

In addition to identifying the type of fault and the phase or phases involved, the computer may be arranged to indicate the fault direction. The method used is to compare the phases of the appropriate post-fault current and the corresponding pre-fault voltage.

For single phase to ground faults a fault on the line side is taken to have occurred if the post-fault, faulted phase current lags the pre-fault, faulted phase voltage by less than 135° or leads it by less than 45°. A fault on the source side is thus indicated if this current leads the voltage by more than 45° or lags it by more than 135°.

For phase to phase and phase to phase to ground faults the same test is applied to the post-fault line current and pre-fault line voltage between the faulted phases.

For three phase faults the same test is applied to any post-fault phase or line current and the corresponding pre-fault voltage.

In order to enable the computer 25 to carry out the above phase comparisons the phases of the various quantities concerned are determined relative to a particular reference point on a pre-fault voltage quantity waveform as opposed to a point defined by the moment when a set value is first exceeded. The phases of the current quantities relative to the latter point are, of course, available by use of the algorithm described above for fault type identification.

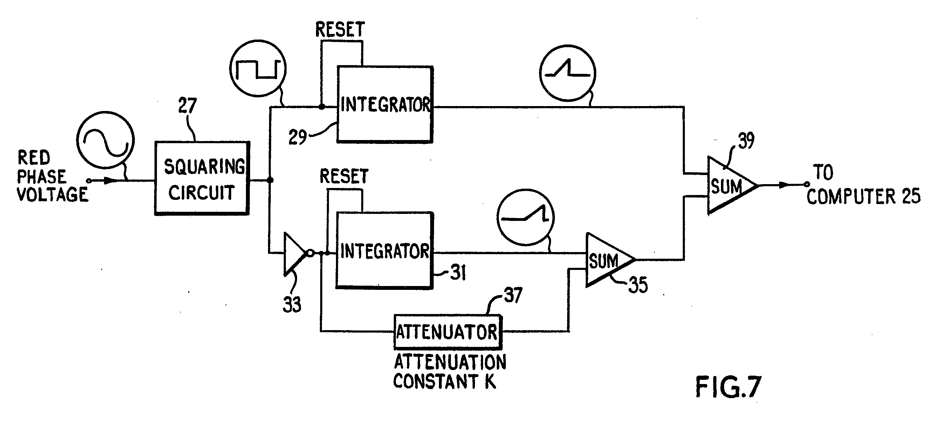

A circuit for defining the required reference point at a positive going zero crossing in the red phase pre-fault voltage is shown in Figure 7. The circuit operates to determine the phase angle between the moment when a set value is first exceeded and the previous positive-going zero crossing in the red-phase pre-fault voltage.

Referring to Figure 7, the circuit includes a waveform squaring circuit 27 to which a voltage corresponding to the red phase voltage is applied via a voltage transformer (not shown). The output of the squarer 27 is applied to two integrators 29 and 31, one integrator 31 being supplied with the squarer output via an inverter 33. The output of the integrator 31 is applied to one input of a summing circuit 35 whose other input is supplied by an attenuator 37 whose input is derived from the output of the inverter 33.

The outputs of the summing circuit 35 and the integrator 29 are summed in a further summing circuit 39 whose output is fed to the computer 25.

It operation the integrators 29 and 31 are reset at each zero crossing of the input signal and produce voltage ramps of the same polarity during positive and negative half cycles of the input voltage respectively. The attenuator constant K is set so that the attenuator output during negative half cycles is equal to the output of the integrator 29 at the end of a half cycle when it is integrating. The output of the summing circuit 39 is thus a ramp voltage rising continuously over each full cycle of the input voltage, being reset at each positive-going zero crossing.

When the computer detects a fault the output of the summing circuit 39 is immediately read by the computer, this output being representative of the phase angle between the moment when a set value is first exceeded and the preceding positive-going zero crossing in the red phase pre-fault voltage.

Using this output the phase of any particular pre-fault voltage required for fault direction determination can easily be determined with respect to the reference point by simple vector relationships.

Similarly, the phase of any particular post-fault current required for fault direction determination can easily be determined with respect to the reference point since the phase of all such currents relative to the moment that a set value is first exceeded is already available. However, allowance must be made for any phase shift at system frequency produced by the transactors 7, 9, 11 and the filters 19, 21, 23.

Having thus established the phases of the required pre-fault voltage and post-fault current with respect to a common reference point, their phase difference and the fault direction can be determined as described above.

The circuit of Figure 7 may be of digital or analogue form, but in the latter case the output of the summing circuit 39 must, of course, be digitised for use by the computer 25.

It will be understood that in the method and apparatus described above by way of example fault detection and direction is carried out on the basis of fault current quantities. However, it will be appreciated that in methods and apparatus for use in a system wherein fault currents greatly exceed load (pre-fault) currents, e.g. a lightly loaded system, post-fault currents differ very little from fault currents and may be used instead of fault currents. Moreover, by appropriately adjusting the set values, post-fault currents can be used even when the load currents may be an appreciable proportion of the post-fault currents.

It should thus be understood that the term fault current quantity as used in the present specification embraces any current quantity, e.g. post-fault current, which can in the context of a particular system, be considered as equivalent to fault current.

It will be appreciated that the present invention is theoretically applicable to fault identification in polyphase power transmission systems having other than three phases, although in practice the number of phases is rarely, if ever, other than three.

**Claims**

1. A method of identifying faults in a polyphase alternating current electric power transmission

6

**0 020 047**

system wherein identification of the type of fault occurring is effected by monitoring a plurality of signals each of which is representative of a respective one of a plurality of fault current quantities, each of which quantities is a linear function of at least one phase fault current of the system, the phase fault currents being defined by the respective differences between the pre-fault and the post-fault currents on the individual phase lines of the system, characterised in that said signals are utilised to determine whether a predetermined phase relation exists between selected ones of said fault current quantities and whether selected ones of said fault current quantities exist, the selected fault current quantities and said predetermined phase relation being such that the result of said determination indicates whether a particular type of fault is present.

2. A method according to Claim 1 wherein each said fault current quantity is a phase fault current of the system or a quantity derived by addition or subtraction of phase fault currents of the system.

3. A method according to Claim 2 for use in a three-phase system wherein said fault current quantities are at least some of the quantities Ir, Iy, Ib, Ir+Iy+Ib, Ir+Iy, Iy+Ib, Ib+Ir, Ir—Iy, Iy—Ib and Ib—Ir, where Ir, Iy and Ib are the respective phase fault currents.

4. A method according to Claim 3 wherein the presence of a ground fault on a single phase of the system is identified by determining that Ir+Iy+Ib exists and that two of the difference currents Ir—Iy, Iy—Ib and Ib—Ir exist and are in-phase or anti-phase with Ir+Iy+Ib and the other difference current does not exist.

5. A method according to Claim 3 wherein the presence of a ground fault on a single phase of the system is identified by determining that the sum currents Ir+Iy, Iy+Ib and Ib+Ir all exist and are in phase or antiphase with Ib, Ir and Iy, respectively.

6. A method according to any one of Claims 3 to 5 wherein the presence of a phase-to-phase fault is identified by determining that Ir+Iy+Ib does not exist and that of the three sum currents Ir+Iy, Iy+Ib and Ib+Ir, the three difference currents Ir—Iy, Iy—Ib and Ib—Ir or the three phase currents Ir, Iy and Ib, only one does not exist and the other two exist and are antiphase.

7. A method according to any one of Claims 3 to 6 wherein the presence of a two phases to ground fault is identified by determining that Ir+Iy+Ib and the sum currents Ir+Iy, Iy+Ib and Ib+Ir all exist but only one sum current is in phase or antiphase with Ir+Iy+Ib.

8. A method according to any one of Claims 3 to 6 wherein the presence of a two phases to ground fault is identified by determining that the sum currents Ir+Iy, Iy+Ib and Ib+Ir will exist but only one sum current is in phase or antiphase with the phase current Ir, Iy or Ib not involved in that sum current.

9. A method according to any one of Claims 3 to 8 wherein the presence of a three phase fault is identified by determining that Ir+Iy+Ib exists and that the three sum currents Ir+Iy, Iy+Ib and Ib+Ir, the difference currents Ir—Iy, Iy—Ib and Ib—Ir or the three phase currents Ir, Iy and Ib all exist and are at 120° phase separations.

10. A method according to any preceding claim wherein the direction of an identified fault is determined by comparing the phases of a post fault current relating to the faulted phase or phases and the corresponding pre-fault voltage.

11. A method according to Claim 10 wherein for a single phase to ground fault a fault on the line side of the monitoring position is taken to have occurred if the faulted phase post-fault current lags the faulted phase pre-fault voltage by less than 135° or leads it by less than 45°.

12. A method according to Claim 10 wherein for phase to phase faults and two phases to ground faults a fault on the line side of the monitoring position is taken to have occurred if the post-fault line current between the faulted phases lags the pre-fault line voltage between the faulted phases by less than 135° or leads it by less than 45°.

13. An apparatus for identifying faults in a polyphase alternating current electric power transmission system comprising: a plurality of current transducer means (1 to 23) for producing respective output signals representing the phase currents of the system; and means (25) arranged to derive from said transducer output signals a plurality of further signals each of which is representative of a respective one of a plurality of fault current quantities, each of which quantities is a linear function of at least one phase fault current of the system, the phase fault currents being defined by the respective differences between the pre-fault and the post-fault currents on the individual phase lines of the system, said means (25) being arranged to monitor said further signals to identify the type of fault occurring in the system, characterised in that said means comprises computer means (25) programmed to utilise said further signals to determine whether a predetermined phase relation exists between selected ones of said fault current quantities and whether selected ones of said fault current quantities exist, the selected current quantities and said predetermined phase relation being such that the result of said determination indicates how many phases a fault condition occurring in the system involves and whether ground is involved in the fault condition.

14. An apparatus according to Claim 13 wherein the computer means carries out fault identification from fault current quantities obtained by storing samples of the transducer means (1 to 23) output signals in respect of at least a quarter of a cycle of each output signal waveform, and subtracting each new sample of the output signal from the stored sample value of the corresponding output signal of a preceding cycle relating to the same point on wave as the new sample.

7

15. An apparatus according to Claim 14 wherein the amplitude and the phase of each fault current quantity required for fault identification relative to a common time reference is calculated by the computer using the algorithms.

$$\phi = \text{arc tan} \left[ \frac{\sin \omega \Delta t}{\dfrac{i_2}{i_1} - \cos \omega \Delta t} - \omega t_1 \right]$$

and

$$\hat{I} = \frac{i_1}{\sin \left( \text{arc tan} \left[ \dfrac{\sin \omega \Delta t}{\dfrac{i_2}{i_1} - \cos \omega \Delta t} \right] \right)}$$

where
$\phi$ is the phase of the fault current quantity relative to the time reference
$\hat{I}$ is the amplitude of the fault current quantity
$i_1$ and $i_2$ are samples of the instantaneous values of the fault current quantity at times $t_1$ and $t_1 + \Delta t$ after the time reference and
$\omega$ is the angular frequency of the system.

16. An apparatus according to Claim 15 wherein the computer continuously monitors the fault current quantity amplitudes and, from the moment when any of these exceeds a predetermined set limit, calculates the fault current amplitudes and relative phase angles using the time at which a set limit was first exceeded as the common time reference.

17. An apparatus according to Claim 16 wherein the computer is further programmed to indicate fault direction by comparing the phases of a post fault current relating to the faulted phase or phases and the corresponding pre-fault voltage, the phase of the relevant post fault current relative to the relevant pre-fault voltage being obtained by determining the phase angle between the moment when a set limit is first exceeded and a predetermined point on the relevant pre-fault voltage and adding this to the phase relation between said relevant post fault current and said time reference.

## Patentansprüche

1. Verfahren zum Erkennen von Fehlern in einem mehrphasigen elektrischen Wechselstromübertragungssystem, wobei das Erkennen der Art des auftretenden Fehlers durch Ueberwachen einer Mehrzahl von Signalen erfolgt, von denen jedes eine betreffende von einer Mehrzahl von Fehlerstromgrössen darstellt, jede dieser Grössen eine lineare Funktion wenigstens eines Phasenfehlerstromes des Systems ist, die Phasenfehlerströme durch die Differenzen zwischen den betreffenden Strömen vor und nach dem Auftreten des Fehlers auf den einzelnen Phasenleiter des Systems definiert sind, gekennzeichnet durch das Benützen der genannten Signale zum Bestimmen ob eine vorbestimmte Phasenbeziehung zwischen ausgewählten der genannten Fehlerstromgrössen besteht, und wenn ausgewählte Fehlerstromgrössen vorhanden sind, ob die ausgewählten Fehlerstromgrössen und die genannte Phasenbeziehung so sind, dass das Ergebnis der genannten Bestimmung anzeigt, wenn eine besondere Fehlerart vorliegt.

2. Verfahren nach Anspruch 1, dadurch gekennzeichnet, dass jede der genannten Fehlerstromgrössen ein Phasenfehlerstrom des Systems oder eine durch Addition oder Subtraktion der Phasenfehlerströme des Systems erhaltene Grösse ist.

3. Verfahren nach Anspruch 2 zum Benützen in einem Dreiphasensystem, dadurch gekennzeichnet, dass die genannten Fehlerstromgrössen wenigstens einige der Grössen Ir, Iy, Ib, Ir+Iy+Ib, Ir+Iy, Iy+Ib, Ib+Ir, Ir—Iy, Iy—Ib und Ib—Ir sind, wobei Ir, Iy und Ib die betreffenden Phasenfehlerströme sind.

4. Verfahren nach Anspruch 3, dadurch gekennzeichnet, dass das Vorhandensein eines Erdfehlers auf einer einzelnen Phase des Systems erkannt wird durch Feststellen, dass Ir+Iy+Ib vorhanden sind und zwei der Differenzströme Ir—Iy, Iy—Ib und Ib—Ir vorhanden sind, dass sie in Phase oder in Gegenphase gegenüber Ir+Iy+Ib sind und dass keine anderen Differenzströme vorhanden sind.

5. Verfahren nach Anspruch 3, dadurch gekennzeichnet, dass das Vorhandensein eines Erdfehlers auf einer einzelnen Phase des Systems erkannt wird durch Feststellen, dass alle Summenströme Ir+Iy, Iy+Ib und Ib+Ir vorhanden sind und dass sie in Phase oder Gegenphase gegenüber Ib, Ir bzw. Iy sind.

6. Verfahren nach einem der Ansprüche 3 bis 5, dadurch gekennzeichnet, dass das Vorhandensein eines Phasen zu Phasenfehlers erkannt wird durch Feststellen, dass Ir+Iy+Ib nicht vorhanden ist und dass von den drei Summenströmen Ir+Iy, Iy+Ib und Ib+Ir, den drei Differenzströmen

Ir—Iy, Iy—Ib und Ib—Ir oder den drei Phasenströmen Ir, Iy und Ib nur einer nicht vorhanden ist und die beiden vorhandenen in Gegenphase sind.

7. Verfahren nach einem der Ansprüche 3 bis 6, dadurch gekennzeichnet, dass das Vorhandensein eines Zweiphasenfehlers erkannt wird durch Feststellen, dass Ir+Iy+Ib und alle die Summenströme Ir+Iy, Iy+Ib und Ib+Ir vorhanden sind, aber dass nur einer der Summenströme in Phase oder in Gegenphase mit Ir+Iy+Ib ist.

8. Verfahren nach einem der Ansprüche 3 bis 6, dadurch gekennzeichnet, dass das Vorhendensein eines Zweiphasenerdfehlers erkannt wird durch Feststellen, dass alle die Summenströme Ir+Iy, Iy+Ib und Ib+Ir vorhanden sind, und dass aber nur einer der Summenströme in Phase oder Gegenphase mit demjenigen Phasenstrom Ir, Iy oder Ib ist, der nicht an der Bildung des Summenstromes beteiligt ist.

9. Verfahren nach einem der Ansprüche 3 bis 8, dadurch gekennzeichnet, dass das Vorhandensein eines Dreiphasenfehlers erkannt wird durch Feststellen, dass Ir+Iy+Ib vorhanden ist und dass die drei Summenströme Ir+Iy, Iy+Ib und Ib+Ir, die Differenzströme Ir—Iy, Iy—Ib und Ib—Ir oder die drei Phasenströme Ir, Iy und Ib alle vorhanden sind und eine Phasenverschiebung von 120° zueinander aufweisen.

10. Verfahren nach einem der vorangehenden Ansprüche, dadurch gekennzeichnet, dass die Richtung eines erkannten Fehlers bestimmt wird durch Vergleichen der Phasen eines nach dem Auftreten des Fehlers vorhandenen Fehlerstromes in der oder den mit dem Fehler behafteten Phase bzw. Phasen und der entsprechenden Spannung vor dem Auftreten des Fehlers.

11. Verfahren nach Anspruch 10, dadurch gekennzeichnet, dass ein Erdfehler einer einzelnen Phase als ein Fehler auf der Leitungsseite der Ueberwachungsstelle bestimmt wird, wenn der nach dem Auftreten des Fehlers der in der fehlerbehafteten Phase auftretende Fehlerstrom gegenüber der vor dem Auftreten des Fehlers vorhandenen Phasenspannung um weniger als 135° nacheilt oder weniger als 45° voreilt.

12. Verfahren nach Anspruch 10, dadurch gekennzeichnet, dass Phasen- zu Phasenfehler und Zweiphasenerdfehler als ein Fehler auf der Leitungsseite der Ueberwachungsstelle bestimmt wird, wenn der nach dem Fehler auftretende Leiterstrom zwischen den fehlerbehafteten Phasen der vor dem Fehler auftretenden Leiterspannung zwischen den fehlerbehafteten Phasen um weniger als 135° nacheilt oder weniger als 45° voreilt.

13. Einrichtung zur Fehlererkennung in einem mehrphasigen elektrischen Wechselstromübertragungssystem, mit einer Mehrzahl von Stromwandlermittel (1 bis 23) zum Erzeugen von die Phasenströme des Systems darstellenden Ausgangssignalen und Mittel (25) zum Ableiten einer Vielzahl von weiteren Signalen von den genannten Wandlerausgangssignalen, wobei jedes der weiteren Signale eine von einer Vielzahl von Fehlerstromgrössen darstellt, von welchen Grössen jede eine lineare Funktion wenigstens eines Phasenfehlerstromes des Systems ist, die Phasenfehlerströme durch die Differenzen zwischen den betreffenden Strömen vor und nach dem Auftreten des Fehlers auf den einzelnen Phasenleiter des Systems definiert sind und die genannten Mittel (25) zum Ueberwachen der genannten weiteren Signale ausgebildet sind, um die Art des im System auftretenden Fehlers zu erkennen, dadurch gekennzeichnet, dass die genannten Mittel Computermittel (25) umfassen, die so programmiert sind, dass die genannten weiteren Signale benützt werden zum Bestimmen, ob eine vorbestimmte Phasenbeziehung zwischen aus den genannten Fehlerstromgrössen ausgewählten Grössen vorhanden ist, und ob die ausgewählten Grössen der genannten Fehlerstromgrössen vorhanden sind und die ausgewählten Stromgrössen und die genannte vorbestimmte Phasenbeziehung so sind, dass das Ergebnis der genannten Bestimmung anzeigt wie viele Phasen von einem im System auftretenden Fehlerzustand betroffen sind, und ob die Erdung am Fehlerzustand beteiligt ist.

14. Einrichtung nach Anspruch 13, dadurch gekennzeichnet, dass die Computermittel die Fehlererkennung aus den Fehlerstromgrössen durchführt, die erhalten werden durch Speichern von Abtastwerten der Ausgangssignale der Wandlermittel (1 bis 23) während wenigstens einem Viertel eines Zyklus jeder Ausgangssignalwellenform und Subtrahieren jedes neuen Abtastwertes des Ausgangssignals vom gespeicherten Abtastwert des entsprechenden Ausgangssignals eines vorangegangenen Zyklus bezogen auf denselben Punkt der Welle wie der neue Abtastwert.

15. Einrichtung nach Anspruch 14, dadurch gekennzeichnet, dass die Amplitude und Phase jeder für die Fehlererkennung benötigten Fehlerstromgrösse bezüglich einer gemeinsamen Bezugszeit durch den Computer berechnet wird unter Benützung der Algorhythmen

$$\phi = \arctan \left[ \cfrac{\sin \omega\Delta t}{\cfrac{i_2}{i_1} - \cos \omega\Delta t} \right] - \omega t_1$$

und

$$\hat{I} = \cfrac{i_1}{\mathrm{sub} \left( \arctan \left[ \cfrac{\sin \omega\Delta t}{\cfrac{i_2}{i_1} - \cos \omega\Delta t} \right] \right)}$$

wobei $\phi$ die Phase der Fehlerstromgrösse bezüglich der Bezugszeit ist, $\hat{I}$ die Amplitude der Fehlerstromgrösse ist, $i_1$ und $i_2$ Abtastwerte der Fehlerstromgrösse zur Zeit $t_1$ und $t_1 + \Delta t$ nach der Bezugszeit sind und $\omega$ die Kreisfrequenz des Systems ist.

16. Einrichtung nach Anspruch 15, dadurch gekennzeichnet, dass der Computer fortlaufend die Fehlerstromgrössenamplituden überwacht von dem Moment an, wenn irgend eine derselben eine vorgegebene Grenze überschreitet, und die Fehlerstromamplituden und die zugehörigen Phasenwinkel berechnet unter Benützung der Zeit, zu welcher eine gesetzte Grenze erstmalig überschritten wird, als Bezugszeit.

17. Einrichtung nach Anspruch 16, dadurch gekennzeichnet, dass der Computer weiter programmiert ist zum Anzeigen der Fehlerrichtung durch Vergleichen der Phasen eines nach dem Auftreten des Fehlers auftretenden Fehlerstromes der betreffenden fehlerbehafteten Phase oder Phasen und der entsprechenden Spannung vor dem Auftreten des Fehlers, dass die Phase des relevanten Fehlerstromes nach dem Auftreten des Fehlers bezüglich der relevanten Spannung vor dem Auftreten des Fehlers erhalten wird durch Feststellen des Phasenwinkels zwischen dem Moment, zu dem eine gesetzte Grenze erstmalig überschritten wird, und einem vorbestimmten Punkt der relevanten Spannung vor dem Auftreten des Fehlers und durch Addition dieses Phasenwinkels zur Phasenbeziehung zwischen dem genannten relevanten Fehlerstrom nach dem Auftreten des Fehlers und der genannten Bezugszeit.

## Revendications

1. Un procédé d'identification de défauts dans un système de transmission d'énergie électrique par courant alternatif polyphasé, dans lequel une identification du type de défaut se produisant est effectuée par contrôle d'une pluralité de signaux représentant chacun une quantité respective parmi une pluralité de quantités de courant de défaut, chacune desdites quantités est une fonction linéaire d'au moins un courant de défaut de phase du système, les courants de défaut de phase étant définis par les différences respectives entre les courants avant et après défaut dans les lignes de phase individuelles du système, caractérisé en ce que lesdits signaux sont utilisés pour déterminer s'il existe une relation de phase prédéterminée entre des quantités sélectionnées parmi lesdites quantités de courant de défaut et s'il existe des quantités sélectionnées parmi lesdites quantités de courant de défaut, lesdites quantités de courant de défaut sélectionnées et ladite relation de phase prédéterminée étant telles que le résultat de ladite détermination indique si un type particulier de défaut existe.

2. Un procédé selon la revendication 1, dans lequel chacune desdites quantités de courant de défaut est un courant de défaut de phase du système ou bien une quantité obtenue par addition ou soustraction de courants de défaut de phase du système.

3. Un procédé selon la revendication 2, utilisable dans un système triphasé, dans lequel lesdites quantités de courant de défaut sont au moins certaines des quantités Ir, Iy, Ib, Ir+Iy+Ib, Ir+Iy, Iy+Ib, Ib+Ir, Ir—Iy, Iy—Ib et Ib—Ir, où Ir, Iy et Ib désignent les courants de défaut de phase respectifs.

4. Un procédé selon la revendication 3, dans lequel la présence d'un défaut de terre dans une seule phase du système est identifiée en déterminant que Ir+Iy+Ib existe et que deux des différences de courants Ir—Iy, Iy—Ib et Ib—Ir existent et sont en phase ou en non position de phase avec Ir+Iy+Ib et que l'autre différence de courant n'existe pas.

5. Un procédé selon la revendication 3, dans lequel la présence d'un défaut de terre dans une seule phase du système est identifiée en déterminant que les sommes de courants Ir+Iy+Ib et Ib+Ir existent toutes et sont en phase ou en opposition de phase avec respectivement Ib, Ir et Iy.

6. Un procédé selon l'une quelconque des revendications 3 à 5, dans lequel la présence d'un défaut de phase-à-phase est identifié en déterminant que Ir+Iy+Ib n'existe pas et que, parmi les trois sommes de courants Ir+Iy, Iy+Ib et Ib+Ir, les trois différences de courant Ir—Iy, Iy—Ib et Ib—Ir, ou bien les trois courants de phase Ir, Iy et Ib, seulement un n'existe pas et les deux autres existent et sont en opposition de phase.

7. Procédé selon l'une quelconque des revendications 3 à 6, dans lequel la présence d'un défaut entre deux phases et la terre est identifiée en déterminant que Ir+Iy+Ib et les sommes de courants

Ir+Iy, Iy+Ib et Ib+Ir existent toutes mais que seulement une somme de courants est en phase ou en opposition de phase avec Ir+Iy+Ib.

8. Procédé selon l'une quelconque des revendications 3 à 6, dans lequel la présence d'un défaut entre deux phases et la paire est identifiée en déterminant que les sommes de courants Ir+Iy, Iy+Ib et Ib+Ir existent toutes mais que seulement une somme de courants est en phase ou en opposition de phase avec le courant de phase Ir, Iy ou Ib n'intervenant pas dans cette somme de courants.

9. Procédé selon l'une quelconque des revendications 3 à 8 dans lequel la présence d'un défaut concernant trois phases est identifiée en déterminant que Ir+Iy+Ib existe et que les trois sommes de courants Ir+Iy, Iy+Ib et Ib+Ir, les différences de courant Ir—Iy, Iy—Ib et Ib—Ir ou bien les trois courants de phase Ir, Iy et Ib existent tous et sont déphasés de 120°.

10. Procédé selon l'une quelconque des revendication précédentes, dans lequel la direction d'un défaut identifié est déterminée par comparaison des phases d'un courant après défaut se rapportant à la ou aux phases défectueuses et de la tension avant défaut correspondante.

11. Procédé selon la revendication 10, dans lequel pour un défaut entre une seule phase et la terre, un défaut du côté ligne de la position de contrôle est considéré comme s'étant produit si le courant après défaut de la phase défectueuse est en retard sur la tension avant défaut de la phase défectueuse de moins de 135° ou bien est en avance sur celle-ci de moins de 45°.

12. Procédé selon la revendication 10, dans lequel pour des défauts de phase-à-phase et des défauts entre deux phases et la terre, un défaut du côté ligne de la position de contrôle est considéré comme s'étant produit si le courant de ligne après défaut entre les phases défectueuses est en retard sur la tension de ligne avant défaut entre les phases défectueuses de moins de 135° ou bien est en avance sur celle-ci de moins de 45°.

13. Un appareil d'identification de défauts dans un système de transmission d'énergie électrique par courant alternatif polyphasé comprenant: une pluralité de transducteurs de courant (1 à 23) pour produire des signaux de sortie de sortie respectifs représentant les courants de phase du système; et un moyen (25) agencé pour obtenir à partir desdits signaux de sortie des transducteurs une pluralité d'autres signaux représentant chacun une quantité respective parmi une pluralité de quantités de courant de défaut, chacune desdites quantités étant une fonction linéaire d'au moins un courant de défaut de phase du système, les courants de défaut de phase étant définis par les différences respectives entre les courants avant et après défaut dans les lignes de phases individuelles du système, lesdits moyens (25) étant agencés pour contrôler lesdits autres signaux afin d'identifier le type de défaut se produisant dans le système, caractérisé en ce que lesdits moyens comprennent un calculateur (25) programmé de façon à utiliser lesdits autres signaux pour déterminer si une relation de phase prédéterminée existe entre des quantités sélectionnées parmi lesdites quantités de courant de défaut et si des quantités sélectionnées existent parmi lesdites quantités de courant de défaut, lesdites quantités de courant sélectionnées et ladite relation de phase prédéterminée étant telles que le résultat de ladite détermination indique dans combien de phases du système intervient une condition de défaut et si une mise à la terre correspond à la condition de défaut.

14. Un appareil selon la revendication 13, dans lequel le calculateur effectue une identification de défauts à partir de quantités de courants de défaut obtenus par mémorisation d'échantillonns des signaux de sortie des transducteurs (1 à 23) pour au moins un quart d'un cycle de chaque forme d'onde de signal de sortie, et en soustrayant chaque nouvel échantillon du signal de sortie de la valeur d'échantillon mémorisée du signal de sortie correspondant d'un cycle précédent se rapportant au même point de l'onde que le nouvel échantillon.

15. Un appareil selon la revendication 14, dans lequel l'amplitude et la phase de chaque quantité de courant de défaut nécessaire pour une identification de défaut par rapport à une référence de temps commune sont calculées par le calculateur en utilisant les alogorithmes:

$$\theta = \text{arc tg} \left[ \frac{\sin \omega \Delta t}{\dfrac{i_2}{i_1} - \cos \text{co}\Delta t} \right] - \omega \Delta_1$$

et

$$\hat{I} = \frac{i_1}{\sin \left( \text{arc tg} \left[ \dfrac{\sin \omega \Delta t}{\dfrac{i_2}{i_1} - \cos \omega \Delta t} \right] \right)}$$

$\theta$ désigne la phase de la quantité de courant se rapportant à la référence de temps,

$\hat{I}$ désigne l'amplitude de la quantité de courant $i_1$ et $i_2$ sont des échantillons des valeurs instantanées de la quantité de courant aux instants $t_1$ et $t_1+\Delta t$ après la référence de temps, et désigne la fréquence angulaire du système.

16. Un appareil selon la revendication 15, dans lequel le calculateur contrôle de façon continue les amplitudes des quantités de courant de défaut et, à partir du moment où l'une d'elles dépasse une limite de réglage prédéterminée, il calcule les amplitudes de courant de défaut et les angles de phase relatifs en utilisant le temps où une limite de réglage a été dépassée en premier comme la référence de temps commune.

17. Appareil selon la revendication 16, dans lequel le calculateur est en outre programmé de manière à indiquer une direction de défaut par comparaison des phases d'un courant après défaut se rapportant à la ou aux phases défectueuses et de la tension avant défaut correspondante, la phase du courant après défaut par rapport à la tension avant défaut correspondante étant obtenue par détermination de l'angle de phase entre le moment où une limite de réglage est dépassée en premier et un point déterminé sur la tension avant défaut correspondante et en l'ajoutant à la relation de phase existant entre ledit courant après défaut correspondant et ladite référence de temps.

FIG.1

FIG. 2

1

0 020 047

FIG.3a

FIG.3b

FIG.3c

FIG.3d

FIG.3e

FIG.3f

2

FIG.4

START

DOES Ir+Iy+Ib EXIST — NO → DO Ir+Iy AND Iy+Ib AND Ib+Ir EXIST — NO → DO Ir+Iy AND Iy+Ib OR Iy+Ib AND Ir+Ib OR Ir+Ib AND Ir+Iy EXIST — YES

DOES Ir+Iy+Ib EXIST — YES → DO Ir+Iy AND Iy+Ib AND Ib+Ir EXIST

DO Ir+Iy AND Iy+Ib AND Ib+Ir EXIST — YES → ARE Ir+Iy AND Iy+Ib AND Ib+Ir AT 120° — YES → 3 PHASE FAULT

ARE Ir+Iy AND Iy+Ib AND Ib+Ir AT 120° — NO

DO Ir+Iy AND Iy+Ib AND Ib+Ir EXIST — NO → DOES Ir-Iy AND Iy-Ib AND Ib-Ir EXIST — YES

DOES Ir-Iy AND Iy-Ib AND Ib-Ir EXIST — NO → IS JUST ONE OF THE ABOVE ZERO — NO → FAULT UNDETECTED

IS JUST ONE OF THE ABOVE ZERO — YES → PHASE TO EARTH FAULT

DO Ir+Iy AND Iy+Ib OR Iy+Ib AND Ir+Ib OR Ir+Ib AND Ir+Iy EXIST — NO → ARE EXISTING PAIR IN ANTIPHASE — YES → 2 PHASE FAULT

ARE EXISTING PAIR IN ANTIPHASE — NO → FAULT UNDETECTED

IS PHASE OF Ir+Iy+Ib AND Ir+Iy AND Iy+Ib AND Ib+Ir IN PHASE OR ANTIPHASE — YES

IS PHASE OF Ir+Iy+Ib AND Ir+Iy AND Iy+Ib AND Ib+Ir IN PHASE OR ANTIPHASE — NO → DOES ONLY ONE OF THE THREE AGREE

DOES ONLY ONE OF THE THREE AGREE — YES → 2 PHASE TO EARTH FAULT

DOES ONLY ONE OF THE THREE AGREE — NO → FAULT UNDETECTED

IS PHASE OF (Ir AND Iy+Ib) AND (Iy AND Ir+Ib) AND (Ib AND Ir+Iy) IN PHASE OR ANTIPHASE — YES

FIG.5

0020047

4

FIG.6

START

$A_{ryb} > w_1$

$(A_{ry} > w_2) \cdot (A_{yb} > w_2) \cdot (A_{br} > w_2)$

$((A_{ry} > w_2) \cdot (A_{yb} > w_2)) \emptyset ((A_{yb} > w_2) \cdot (A_{br} > w_2)) \emptyset ((A_{br} > w_2) \cdot (A_{ry} > w_2))$

$(A_{ry} > w_2) \cdot (A_{yb} > w_2) \cdot (A_{br} > w_2)$

$(A_{r-y} > w_3) \cdot (A_{y-b} > w_3) \cdot (A_{b-r} > w_3)$

$(A_{r-y} < w_3) \emptyset (A_{y-b} < w_3) \emptyset (A_{b-r} < w_3)$

$(((|a_{ry} - a_{yb}| - \frac{2}{3}\pi| < e) + (||a_{ry} - a_{yb}| - \frac{4}{3}\pi| < e)) \cdot ((||a_{yb} - a_{br}| - \frac{2}{3}\pi| < e) + (||a_{yb} - a_{br}| - \frac{4}{3}\pi| < e)) \cdot ((||a_{br} - a_{ry}| - \frac{2}{3}\pi| < e) + (||a_{br} - a_{ry}| - \frac{4}{3}\pi| < e))$

$(||a_{ry} - a_{yb}| - \pi| < e) \emptyset (||a_{yb} - a_{br}| - \pi| < e) \emptyset (||a_{br} - a_{ry}| - \pi| < e)$

$(((|a_{ryb} - a_r| < e) + (||a_{ryb} - a_r| - \pi| < e)) \cdot ((||a_{ryb} - a_y| < e) + (||a_{ryb} - a_y| - \pi| < e)) \cdot ((||a_{ryb} - a_b| < e) + (||a_{ryb} - a_b| - \pi| < e))$

$(((|a_r - a_y| < e) + (||a_r - a_y| - \pi| < e)) \cdot ((|a_y - a_b| < e) + (||a_y - a_b| - \pi| < e)) \cdot ((|a_b - a_r| < e) + (||a_b - a_r| - \pi| < e))$

$(||a_{ryb} - a_{ry}| - \pi| < e) \emptyset (||a_{ryb} - a_{yb}| - \pi| < e) \emptyset (||a_{ryb} - a_{br}| - \pi| < e)$

$(||a_{ry} - a_b| - \pi| < e) \emptyset (||a_{yb} - a_r| - \pi| < e) \emptyset (||a_{br} - a_y| - \pi| < e)$

FAULT UNDETECTED

2 PHASE TO EARTH FAULT

FAULT UNDETECTED

2 PHASE FAULT

FAULT UNDETECTED

3 PHASE FAULT

PHASE TO EARTH FAULT

FAULT UNDETECTED

T = TRUE
F = FALSE

+  OR
·  AND
⊕  EXCLUSIVE OR
Ū  NOT U
$X \emptyset Y \emptyset Z = \bar{Z} \cdot (X \oplus Y) + Z \cdot \bar{Y} \cdot \bar{X}$
$w_1, w_2, w_3$  AMPLITUDE SET VALUES
$e$  ANGULAR SET VALUES
$I_i = A_i \angle a_i$
$I_{i+j} = A_{ij} \angle a_{ij}$
$I_{i-j} = A_{i-j} \angle a_{i-j}$
$I_{i jk} = A_{ijk} \angle a_{ijk}$
WHERE i,j,k REPRESENT THE SPECIFIED PHASE
a IS THE PHASE WITH RESPECT TO THE TIME OF
FAULT INCIDENCE AND MUST LIE WITHIN
0 AND 2π RADIANS

0 020 047

FIG.7